# EUROPÄISCHE PATENTSCHRIFT

(11) **EP 3 308 894 B1**
(45) Veröffentlichungstag und Bekanntmachung des Hinweises auf die Patenterteilung: **24.07.2019**
(21) Anmeldenummer: 17189850.5
(22) Anmeldetag: 07.09.2017
(51) Int. Cl.: B23K 1/08, B23K 3/06, B23K 3/08, H05K 3/34

(54) **LÖTVORRICHTUNG MIT EINEM OBERTEIL UND EINEM UNTERTEIL UND EINER EINRICHTUNG ZUR ERZEUGUNG EINES BEWEGTEN MAGNETFELDS DER LOTPUMPE**
SOLDERING DEVICE WITH AN UPPER PART AND A LOWER PART, AND WITH A DEVICE FOR ACHIEVING A MOVABLE MAGNETIC FIELD OF THE PUMP
DISPOSITIF DE SOUDAGE AVEC UNE PARTIE SUPERIEURE ET UNE PARTIE INFERIEURE ET UN DISPOSITIF POUR CREER UN CHAMP MAGNETIQUE FLUCTUANT DE LA POMPE

(30) Priorität: 05.10.2016 DE 102016118789
(43) Veröffentlichungstag der Anmeldung: 18.04.2018
(73) Patentinhaber: Ersa GmbH, 97877 Wertheim (DE)
(72) Erfinder: KRESSMANN, Richard, 97299 Zell am Main (DE)
(74) Vertreter: DREISS Patentanwälte PartG mbB

(56) Entgegenhaltungen:
- JP-A- H10 156 527
- JP-A- 2005 205 479
- JP-A- 2008 109 033
- JP-A- 2008 238 192
- JP-A- 2010 207 895

## Beschreibung

Die Erfindung betrifft eine Lötvorrichtung, insbesondere einen Löttiegel zum selektiven Wellenlöten, mit einem Lotreservoir, das zur Aufbewahrung eines Lots, insbesondere eines flüssigen Lots, ausgelegt ist, mit einer Lötdüse und mit einer Lotpumpe, die zum Fördern des Lots aus dem Lotreservoir durch die Lötdüse ausgelegt ist.

Derartige Lötvorrichtungen sind aus dem Stand der Technik vielfach bekannt. Allerdings hat es sich gezeigt, dass derartige Lötvorrichtungen oder Löttiegel beim Einsatz in Lötanlagen zum Wellenlöten oftmals mit gewissen Nachteilen behaftet sind. Dabei ist es bspw. nachteilig, dass bei Verwendung von Loten mit voneinander verschiedenen Legierungen eine große Vielzahl von Lötvorrichtungen oder Löttiegeln vorgehalten werden muss, da in den Lotreservoirs der Lötvorrichtungen oder Löttiegel eine Vermischung verschiedener Lote vermieden werden sollte. Somit muss für jedes Lot ein separater Löttiegel mit einem erheblichen vorzuhaltenden Lotvolumen vorgehalten werden.

Lötvorrichtungen mit Merkmalen des Oberbegriffs des Patentanspruchs 1 sind beispielsweise aus der JP 2010 207895 A oder der JP 2005 205479 A bekannt.

Der Erfindung liegt die Aufgabe zugrunde, eine Lötvorrichtung, insbesondere einen Löttiegel zum selektiven Wellenlöten bereitzustellen, mit der einerseits eine variable Produktion und andererseits eine Senkung der Betriebskosten und der Rüstzeiten ermöglicht werden kann.

Diese Aufgabe wird durch eine Lötvorrichtung mit den Merkmalen des Anspruchs 1 gelöst. Eine derartige Lötvorrichtung zeichnet sich dadurch aus, dass die Lötvorrichtung ein Oberteil und ein Unterteil aufweist, wobei das Oberteil lösbar mit dem Unterteil verbindbar ist und das Lotreservoir und die Lötdüse aufweist, wobei im Oberteil ein Förderkanal der Lotpumpe angeordnet ist und wobei im Unterteil eine Einrichtung zur Erzeugung eines bewegten Magnetfelds der Lotpumpe angeordnet ist, die zur Erzeugung eines bewegten Magnetfelds entlang des Förderkanals ausgelegt ist. Dadurch, dass das Oberteil lösbar mit dem Unterteil verbunden ist und das Lotreservoir und die Lötdüse aufweist, können die Bauteile der Lötvorrichtung bzw. des Löttiegels, die einem verstärkten Verschleiß unterliegen, leicht ausgewechselt werden. Dabei ist es denkbar, dass in einer Lötanlage eine Lötvorrichtung mit jeweils demselben Unterteil verwendet wird, wobei je nach Einsatzzweck oder Verschleißzustand das Oberteil der Lötvorrichtung einfach und vergleichsweise kostengünstig ausgetauscht werden kann, ohne dass die gesamte Lötvorrichtung bzw. der gesamte Löttiegel gewartet werden muss. Ferner kann für verschiedene Lotsorten, d.h. für Lote mit voneinander verschiedenen Legierungen jeweils ein Oberteil vorgesehen sein, wobei für den bestimmungsgemäßen Einsatz in einer Anlage zum selektiven Wellenlöten mehrere Oberteile zur abwechselnden Verwendung mit wenigstens einem Unterteil vorgesehen sein können. Im Vergleich zum Stand der Technik kann durch diese Bauweise ein deutlich geringerer Bauraum erreicht werden. Somit kann durch die Verwendung von verschiedenen Ober- und Unterteilen in einer Lötanlage eine erhöhte Flexibilität im Hinblick auf die Lotlegierung, Düsengröße und Verarbeitung von Mehrfachnutzen erreicht werden. Darüber hinaus kann eine erhöhte Sicherheit im Hinblick auf den Verschleiß erreicht werden, wobei durch redundante Zurverfügungstellung des jeweiligen Werkzeugs geringere Stillstandszeiten erreicht werden können.

Dabei verläuft der Förderkanal zumindest abschnittsweise entlang einer Kreisbahn, wobei die Einrichtung zur Erzeugung eines bewegten Magnetfelds wenigstens einen Magneten, insbesondere wenigstens einen Permanentmagneten umfasst und derart ausgelegt ist, dass der Magnet im Betrieb entlang des Förderkanals bewegt wird.

Um flüssiges Lot einfach und zuverlässig aus dem Lotreservoir zur Lötdüse fördern bzw. pumpen zu können hat es sich als vorteilhaft erwiesen, wenn der Förderkanal einen Einlass und einen Auslass aufweist, wobei der Einlass fluidisch mit dem Lotreservoir verbunden ist und wobei der Auslass fluidisch mit der Lötdüse verbunden ist.

Gemäß einer besonders vorteilhaften Weiterbildung der Lötvorrichtung ist vorgesehen, dass eine Verbindungseinrichtung vorgesehen ist, die zur lösbaren Verbindung des Oberteils und des Unterteils ausgelegt ist.

Dabei ist es beispielsweise denkbar, dass die Verbindungseinrichtung einen Bajonettverschluss und/oder einen Magnetverschluss umfasst. Es ist jedoch auch möglich, dass eine andersartige kraft- und/oder formschlüssige Verbindung gewählt wird.

Um das Lot im Lotreservoir flüssig zu halten hat es sich als vorteilhaft erwiesen, wenn eine Heizeinrichtung vorgesehen ist, die zumindest teilweise im Unterteil angeordnet ist und die zur Beheizung des Lotreservoirs ausgelegt ist. Dabei ist es möglich, dass die Heizeinrichtung bspw. als induktive Heizeinrichtung ausgebildet ist, wobei im Unterteil ein magnetisches Wechselfeld erzeugt wird, wobei im Oberteil eine Schicht aus ferromagnetischem Material vorgesehen ist.

Um die Lötvorrichtung bzw. den Löttiegel in einer Lötanlage verfahren zu können, hat es sich als vorteilhaft erwiesen, wenn eine Antriebseinrichtung vorgesehen ist, die zur Bewegung der Lötvorrichtung ausgelegt ist.

Besonders bevorzugt ist es dabei, wenn die Antriebseinrichtung im Unterteil angeordnet ist.

Dabei ist es möglich, dass die Antriebseinrichtung wenigstens einen Elektromotor und wenigstens ein am Unterteil angeordnetes Antriebsrad aufweist, das mit dem Elektromotor verbunden ist.

Eine weitere vorteilhafte Ausgestaltung der Lötvorrichtung sieht vor, dass eine Zustelleinrichtung vorgesehen ist, die zum relativen Verlagern der Lötdüse entlang einer Z-Achse ausgebildet ist. Vorteilhafterweise ist die Zustelleinrichtung dabei im Unterteil angeordnet. Mit der Zustelleinrichtung kann die Lötdüse eines Löttiegels gegenüber einer zu bearbeitenden Leiterplatte aus einer Ruheposition in eine Lötposition verlagert werden. Dabei ist es denkbar, dass die Zustelleinrichtung elektrisch antreibbar ist. Besonders vorteilhaft ist es dabei, wenn die Zustelleinrichtung von einer insbesondere zentralen Steuereinrichtung einer Lötanlage ansteuerbar ist, so dass einzelne Löttiegel in ein laufendes Lötprogramm einer Lötanlage ein- und ausgekoppelt werden können.

Gemäß einer weiteren vorteilhaften Weiterbildung der Lötvorrichtung ist vorgesehen, dass im Unterteil ein Druckspeicher vorgesehen ist, der zur Speicherung eines unter einem Überdruck stehenden Druckgases ausgelegt ist. Vorteilhafterweise ist der Druckspeicher zur Speicherung von Stickstoff ausgelegt.

Dabei hat es sich als vorteilhaft erwiesen, wenn im Unterteil eine erste Druckgasleitung vorgesehen ist, die mit dem Druckspeicher fluidisch verbindbar ist, und wobei im Oberteil eine zweite Druckgasleitung vorgesehen ist, die derart angeordnet ist, dass die zweite Druckgasleitung bei am Unterteil angeordneten Oberteil mit der ersten Druckgasleitung fluidisch verbunden ist. Vorteilhafterweis hat die zweite Druckgasleitung dabei einen Auslass, der im Bereich der Lötdüse mündet, so dass Druckgas, bspw. Stickstoff im Betrieb der Lötvorrichtung bzw. des Löttiegels vom Unterteil zur Lötdüse des Oberteils geleitet werden kann.

Um Lot vom Lotreservoir zur Lötdüse fördern bzw. pumpen zu können, ist es vorteilhaft, wenn die Einrichtung zur Erzeugung eines bewegten Magnetfelds derart ausgelegt ist, dass der Permanentmagnet im Betrieb um eine konzentrisch zur Kreisbahn angeordnete Rotationsachse rotiert.

Vorteilhafterweise ist dabei eine Vielzahl von Permanentmagneten vorgesehen, die dem Förderkanal alternierend mit einem voneinander verschiedenen Magnetpol zugewandt sind. Besonders vorteilhaft ist es ferner, wenn die Permanentmagneten auf einer Magnetkreisbahn angeordnet sind, die konzentrisch zur Kreisbahn des Förderkanals angeordnet ist, wobei die Magnetkreisbahn einen Magnetkreisbahndurchmesser aufweist und wobei die Kreisbahn des Förderkanals einen Kreisbahndurchmesser aufweist, wobei der Magnetkreisbahndurchmesser und der Kreisbahndurchmesser identisch oder nahezu identisch sind. Besonders vorteilhaft ist es, wenn die Einrichtung zur Erzeugung eines bewegten Magnetfelds einen Elektromotor umfasst, wobei der wenigstens eine Permanentmagnet zur Rotation um die Rotationsachse von dem Elektromotor antreibbar ist. Weiterhin ist es vorteilhaft, wenn auf der dem Permanentmagneten abgewandten Seite des Förderkanals im Oberteil der Vorrichtung ein magnetisches oder ferromagnetisches Material angeordnet ist.

Weitere Einzelheiten und vorteilhafte Weiterbildungen der Erfindung sind der nachfolgenden Beschreibung zu entnehmen, anhand derer eine Ausführungsform der Erfindung näher beschrieben und erläutert ist.

Es zeigen:
Figur 1 eine schematische Seitenansicht einer erfindungsgemäßen Lötvorrichtung;
Figur 2 eine schematische Ansicht eines Abschnitts der Lötvorrichtung gemäß Figur 1; und
Figur 3 ein Förderkanal der Lötvorrichtung gemäß Figur 1 in einer Draufsicht.

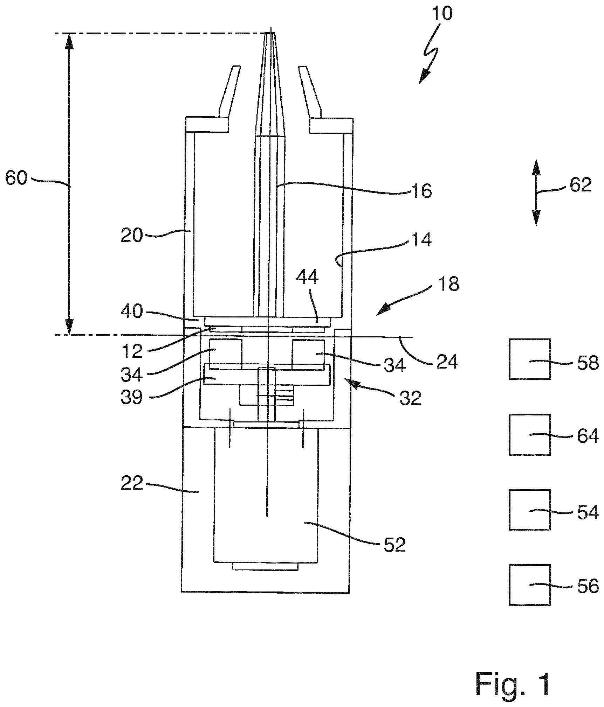

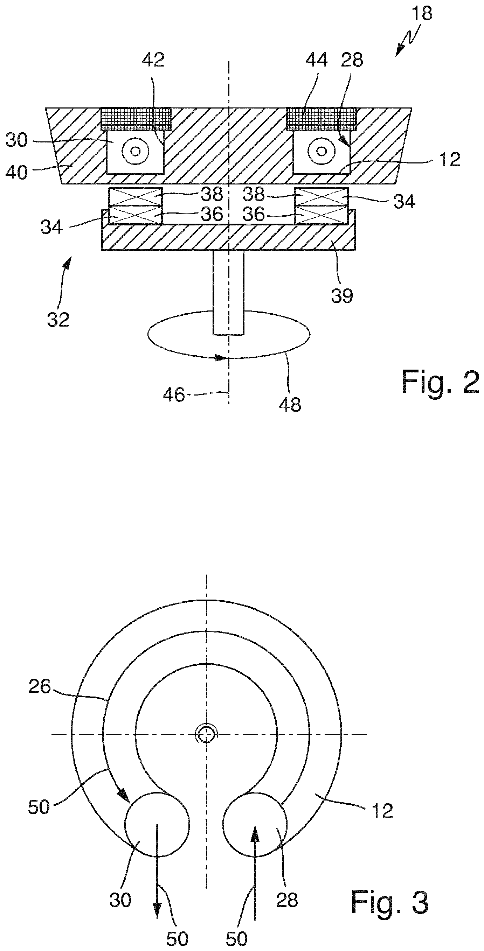

Figur 1 zeigt eine schematische Seitenansicht einer erfindungsgemäßen Lötvorrichtung 10, insbesondere eines Löttiegels zum selektiven Wellenlöten, wobei Figur 2 vergrößert eine schematische Ansicht eines Abschnitts der Lötvorrichtung 10 gemäß Figur 1 zeigt. In Figur 3 ist ferner ein Förderkanal 12 der Lötvorrichtung 10 gemäß Figur 1 gezeigt. Sich in den Figuren entsprechende Bauteile und Elemente sind mit den sich entsprechenden Bezugszeichen gekennzeichnet.

Die Lötvorrichtung 10 weist ein Lotreservoir 14, das zur Aufbewahrung eines Lots, insbesondere eines flüssigen Lots, ausgelegt ist, sowie eine Lötdüse 16 auf. Darüber hinaus weist die Lötvorrichtung 10 eine Lotpumpe 18 auf, die zum Fördern des Lots aus dem Lotreservoir 14 durch die Lötdüse 16 ausgelegt ist, so dass zum selektiven Wellenlöten eine stehende Welle aus Lot erzeugt werden kann.

Die Lötvorrichtung 10 weist ein Oberteil 20 und ein Unterteil 22 auf, wobei das Oberteil 20 lösbar mit dem Unterteil 22 verbindbar ist und das Lotreservoir 14 und die Lötdüse 16 aufweist. Zur lösbaren Verbindung des Oberteils 20 mit dem Unterteil 22 kann eine in den Figuren nicht gezeigte Verbindungseinrichtung vorgesehen sein, die zur lösbaren Verbindung des Oberteils 20 und des Unterteils 22 ausgelegt ist. Dabei ist es beispielsweise denkbar, dass die Verbindungseinrichtung einen Bajonettverschluss und/oder einen Magnetverschluss umfasst. Es ist jedoch auch möglich, dass eine andersartige kraft- und/oder formschlüssige Verbindung gewählt wird. Das Oberteil 20 und das Unterteil 22 lassen sich dabei im Bereich einer in Figur 1 schematisch gezeigten Trennebene 24 voneinander trennen.

Im Oberteil 20 der Lötvorrichtung 10 ist ein Förderkanal 12 der Lotpumpe 18 angeordnet. Dieser Förderkanal 12 ist in Figur 1 gezeigt, jedoch in den Figuren 2 und 3 deutlicher zu erkennen.

Der Förderkanal 12 verläuft zumindest abschnittsweise entlang einer Kreisbahn 26 (vgl. Figur 3) und weist einen Einlass 28 und einen Auslass 30 auf, wobei der Einlass 28 fluidisch mit dem Lotreservoir 14 verbunden ist und wobei der Auslass 30 fluidisch mit der Lötdüse 16 verbunden ist. Der Förderkanal 12 ist in Figur 3 schematisch in einer Draufsicht gezeigt. Der Einlass 28, der Auslass 30 sowie die Kreisbahn 26 sind dabei deutlich zu erkennen. Der Einlass 28 und der Auslass 30 sind an den einander abgewandten Enden des Förderkanals 12 angeordnet.

Die Lötvorrichtung 10 weist ferner eine Einrichtung zur Erzeugung eines bewegten Magnetfelds 32 auf, die im Unterteil 22 der Lötvorrichtung 10 angeordnet ist. Die Einrichtung zur Erzeugung eines bewegten Magnetfelds 32 umfasst wenigstens einen Permanentmagneten 34 und ist derart ausgelegt, dass der Permanentmagnet 34 im Betrieb entlang des Förderkanals 12 bewegt wird. In der Ausführungsform gemäß der Figuren 1 bis 3 umfasst die Lötvorrichtung 10 bzw. die Einrichtung 20 eine Vielzahl von Permanentmagneten 34, die dem Förderkanal 12 alternierend mit einem voneinander verschiedenen Magnetpol 36, 38 zugewandt sind.

Die Permanentmagnete 34 sind dabei auf einer in den Figuren nicht gezeigten Magnetkreisbahn angeordnet, die konzentrisch zur Kreisbahn 26 des Förderkanals 12 angeordnet ist, wobei jeweils ein Permanentmagnet 34 mit einem Südpol 38 nach oben, d.h. dem Förderkanal 12 zugewandt angeordnet ist und der daneben angeordnete Permanentmagnet 34 mit einem Nordpol 36 nach oben angeordnet ist. Die Permanentmagnete 34 sind in Figur 2 auf einer Magnetscheibe 39 montiert, die ebenfalls deutlich in Figur 1 zu erkennen ist.

Der Förderkanal 12 wird, wie in Figur 1 und 2 zu erkennen ist, von einem nicht ferromagnetischen Material 40 begrenzt, in das eine Nut 42 eingebracht ist. Diese Nut 42 wird von einem Ring 44 aus ferromagnetischem Material verschlossen, wobei der Förderkanal 12 insgesamt von dem nicht ferromagnetischen Material 40 und dem ferromagnetischen Ring 44 begrenzt wird.

Die Einrichtung 32 zur Erzeugung eines bewegten Magnetfeldes ist derart ausgelegt, dass die Permanentmagnete 34 im Betrieb um eine konzentrisch zur Kreisbahn 26 oder Magnetkreisbahn angeordnete Rotationsachse 46 rotieren. Durch Rotation der axial (parallel zur Richtung der Rotationsachse 46) unterhalb des Förderkanals 12 angeordneten Permanentmagnete 34 kann im Förderkanal 12 ein bewegtes Magnetfeld erzeugt werden, das sich zwischen dem ferromagnetischen Material 44 und den Permanentmagneten 34 ausbildet. Durch das bewegte Magnetfeld können im Betrieb der Lotpumpe 18 der Lötvorrichtung 10 in einem elektrisch leitfähigen Fluid insbesondere in einem flüssigen Lot, Wirbelströme erzeugt werden. Durch Erzeugung der Wirbelströme kann das elektrisch leitfähige Fluid bzw. das flüssige Lot entlang einer durch den Pfeil 48 in Figur 2 oder durch die Pfeile 50 in Figur 3 dargestellten Rotationsrichtung entlang des zumindest abschnittsweise entlang der Kreisbahn 26 verlaufenden Förderkanals 12 beschleunigt werden und somit kann eine Pumpenwirkung der Lotpumpe 18 bereitgestellt werden.

Zum Antrieb der Magnetscheibe 39 weist die Lotpumpe 18 einen in Figur 1 schematisch gezeigten Elektromotor 52 auf, welcher die Magnetscheibe 39 bzw. die Permanentmagnete 34 derart antreibt, dass diese um die Rotationsachse 46 rotieren. Vorteilhafterweise ist die Magnetscheibe 39 aus einem ferromagnetischen Material, insbesondere aus einem eisenhaltigen Material hergestellt.

Dadurch, dass das Oberteil 20 lösbar mit dem Unterteil 22 verbunden ist und das Lotreservoir 14 und die Lötdüse 16 aufweist, können die Bauteile der Lötvorrichtung 10 bzw. des Löttiegels, die einem verstärkten Verschleiß unterliegen, leicht ausgewechselt werden. Dabei ist es denkbar, dass in einer Lötanlage eine Lötvorrichtung 10 mit jeweils demselben Unterteil 22 verwendet wird, wobei je nach Einsatzzweck oder Verschleißzustand das Oberteil 20 der Lötvorrichtung 10 einfach und vergleichsweise kostengünstig ausgetauscht werden kann, ohne dass die gesamte Lötvorrichtung 10 bzw. der gesamte Löttiegel gewartet werden muss.

Um das Lot im Lotreservoir 14 zu verflüssigen, ist eine in Figur 1 schematisch gezeigte Heizeinrichtung 54 vorgesehen ist, die im Unterteil 22 angeordnet ist und die zur Beheizung des Lotreservoirs 14 ausgelegt ist. Dabei ist es möglich, dass die Heizeinrichtung 54 bspw. als induktive Heizeinrichtung ausgebildet ist, wobei im Unterteil 22 ein magnetisches Wechselfeld erzeugt wird, wobei im Oberteil 20 eine Schicht aus ferromagnetischem Material vorgesehen ist.

Ferner ist eine in Figur 1 schematisch gezeigte Antriebseinrichtung 56 vorgesehen, die zur Bewegung der Lötvorrichtung 10 in einem Arbeitsraum ausgelegt ist und am oder im Unterteil 22 angeordnet ist. Die Antriebseinrichtung 56 weist dabei wenigstens einen Elektromotor auf, der zusätzlich zum Elektromotor 52 vorgesehen ist. Ferner weist die Antriebseinrichtung 56 wenigstens ein am Unterteil 22 angeordnetes, in den Figuren jedoch nicht gezeigtes Antriebsrad auf, das mit dem Elektromotor verbunden ist.

Die Lötvorrichtung 10 weist darüber hinaus eine in Figur 1 schematisch gezeigte Zustelleinrichtung 58 auf, die zum relativen Verlagern der Lötdüse 16 entlang einer Z-Achse ausgebildet ist. Die Zustelleinrichtung 58 kann insbesondere zur Verstellung eines Abstands 60 zwischen der Lötdüse 16 und einem nicht verfahrbaren Abschnitt des Unterteils 22 ausgelegt sein, so dass eine Art Z-Achsenantrieb in Richtung des Doppelpfeils 62 realisiert werden kann. Mit der Zustelleinrichtung 58 kann die Lötdüse 16 einer Lötvorrichtung 10 bzw. eines Löttiegels gegenüber einer zu bearbeitenden Leiterplatte aus einer Ruheposition in eine Lötposition verlagert werden. Dabei ist es denkbar, dass die Zustelleinrichtung 58 elektrisch antreibbar ist. Besonders vorteilhaft ist es dabei, wenn die Zustelleinrichtung 58 von einer insbesondere zentralen Steuereinrichtung einer Lötanlage ansteuerbar ist, so dass einzelne Lötvorrichtungen 10 oder Löttiegel in ein laufendes Lötprogramm einer Lötanlage ein- und ausgekoppelt werden können.

Im Unterteil 22 der Lötvorrichtung 10 ist ein in Figur 1 angedeuteter Druckspeicher 64 vorgesehen, der zur Speicherung eines unter einem Überdruck stehenden Druckgases ausgelegt ist. Vorteilhafterweise ist der Druckspeicher 64 zur Speicherung von Stickstoff ausgelegt. Dabei ist im Unterteil 22 eine erste in den Figuren nicht gezeigte Druckgasleitung vorgesehen, die mit dem Druckspeicher 64 fluidisch verbindbar ist, wobei im Oberteil 20 eine zweite in den Figuren nicht gezeigte Druckgasleitung vorgesehen ist, die derart angeordnet ist, dass die zweite Druckgasleitung bei am Unterteil 22 angeordneten Oberteil 20 mit der ersten Druckgasleitung fluidisch verbunden ist. Die zweite Druckgasleitung weist dabei einen Auslass auf, der im Bereich der Lötdüse 16 mündet, so dass Druckgas, bspw. Stickstoff im Betrieb der Lötvorrichtung 10 bzw. des Löttiegels vom Unterteil 22 zur Lötdüse 16 des Oberteils 20 geleitet werden kann.

## Patentansprüche

1. Lötvorrichtung (10), insbesondere Löttiegel zum selektiven Wellenlöten, mit einem Lotreservoir (14), das zur Aufbewahrung eines elektrisch leitfähigen Lots, insbesondere eines flüssigen Lots, ausgelegt ist, mit einer Lötdüse (16) und mit einer Lotpumpe (18), die zum Fördern des Lots aus dem Lotreservoir (14) durch die Lötdüse (16) ausgelegt ist, wobei die Lötvorrichtung (10) ein Oberteil (20) und ein Unterteil (22) aufweist, wobei das Oberteil (20) lösbar mit dem Unterteil (22) verbindbar ist und das Lotreservoir (14) und die Lötdüse (16) aufweist, wobei im Oberteil (20) ein Förderkanal (12) der Lotpumpe (18) angeordnet ist, und wobei im Unterteil (22) eine Einrichtung (32) zur Erzeugung eines bewegten Magnetfelds der Lotpumpe (18) angeordnet ist, **dadurch gekennzeichnet,**
**dass** der Förderkanal (12) zumindest abschnittsweise entlang einer um eine Rotationsachse (46) verlaufende Kreisbahn (26) verläuft, und
**dass** die Einrichtung zur Erzeugung eines bewegten Magnetfelds wenigstens einen Magneten (34) umfasst und derart ausgelegt ist, dass der Magnet (34) im Betrieb um die konzentrisch zur Kreisbahn (26) angeordnete Rotationsachse (46) entlang des Förderkanals (12) zur Erzeugung von Wirbelströmen im flüssigen Lot zum Beschleunigen des flüssigen Lots im Förderkanal bewegt wird, so dass eine Pumpenwirkung der Lotpumpe (18) bereitgestellt wird.

2. Lötvorrichtung (10) nach Anspruch 1, wobei der Förderkanal (12) einen Einlass (28) und einen Auslass (30) aufweist, wobei der Einlass (28) fluidisch mit dem Lotreservoir (14) verbunden ist und wobei der Auslass (30) fluidisch mit der Lötdüse (16) verbunden ist.

3. Lötvorrichtung (10) nach einem der vorherigen Ansprüche, wobei eine Verbindungseinrichtung vorgesehen ist, die zur lösbaren Verbindung des Oberteils (20) und des Unterteils (22) ausgelegt ist.

4. Lötvorrichtung (10) nach Anspruch 3, wobei die Verbindungseinrichtung einen Bajonettverschluss und/oder einen Magnetverschluss umfasst.

5. Lötvorrichtung (10) nach einem der vorherigen Ansprüche, wobei eine Heizeinrichtung (54) vorgesehen ist, die zumindest teilweise im Unterteil (22) angeordnet ist und die zur Beheizung des Lotreservoirs (14) ausgelegt ist.

6. Lötvorrichtung (10) nach einem der vorherigen Ansprüche, wobei eine Antriebseinrichtung (56) vorgesehen ist, die zur Bewegung der Lötvorrichtung (10) ausgelegt ist.

7. Lötvorrichtung (10) nach Anspruch 6, wobei die Antriebseinrichtung (56) im Unterteil angeordnet ist.

8. Lötvorrichtung (10) nach Anspruch 6 oder 7, wobei die Antriebseinrichtung (56) wenigstens einen Elektromotor und wenigstens ein am Unterteil (22) angeordnetes Antriebsrad aufweist, das mit dem Elektromotor verbunden ist.

9. Lötvorrichtung (10) nach einem der vorherigen Ansprüche, wobei eine Zustelleinrichtung (56) vorgesehen ist, die zum relativen Verlagern der Lötdüse (16) entlang einer Z-Achse ausgebildet ist.

10. Lötvorrichtung (10) nach einem der vorherigen Ansprüche, wobei im Unterteil (22) ein Druckspeicher (64) vorgesehen ist, der zur Speicherung eines unter einem Überdruck stehenden Druckgases ausgelegt ist.

11. Lötvorrichtung (10) nach Anspruch 10, wobei im Unterteil (22) eine erste Druckgasleitung vorgesehen ist, die mit dem Druckspeicher (64) fluidisch verbindbar ist, und wobei im Oberteil (20) eine zweite Druckgasleitung vorgesehen ist, die derart angeordnet ist, dass die zweite Druckgasleitung bei am Unterteil (22) angeordneten Oberteil (20) mit der ersten Druckgasleitung fluidisch verbunden ist.

12. Lötvorrichtung (10) nach einem der Ansprüche 1 bis 11, wobei eine Vielzahl von Permanentmagneten (34) vorgesehen ist, die dem Förderkanal (12) alternierend mit einem voneinander verschiedenen Magnetpol (36, 38) zugewandt sind.

## Claims

1. A soldering device (10), in particular a soldering crucible for selective flow soldering, having a solder reservoir (14) which is designed for storing an electrically conductive solder, in particular a liquid solder, having a solder nozzle (16) and having a solder pump (18) which is designed for conveying the solder from the solder reservoir (14) through the solder nozzle (16), wherein the soldering device (10) having an upper part (20) and a lower part (22), wherein the upper part (20) being releasably connectable to the lower part (22) and having the solder reservoir (14) and the solder nozzle (16), wherein a feed channel (12) of the solder pump (18) being arranged in the upper part (20), and wherein a device (32) for generating a moving magnetic field of the solder pump (18) being arranged in the lower part (22), **characterized in that** the feed channel (12) runs at least in portions along a circular path (26) extending about an axis of rotation (46), and **in that** the device for generating a moving magnetic field comprises at least one magnet (34) and is arranged such that, in operation, the magnet (34) is moved about the axis of rotation (46) concentric with the circular path (26) along the feed channel (12) for generating eddy currents in liquid solder for accelerating the liquid solder in the feed channel (12), so that a pumping effect of the solder pump (18) is provided.

2. The soldering device (10) according to claim 1, wherein the feed channel (12) has an inlet (28) and an outlet (30), the inlet (28) being fluidically connected to the solder reservoir (14) and the outlet (30) being fluidically connected to the soldering nozzle (16).

3. The soldering device (10) according to one of the preceding claims, wherein a connecting device designed for releasable connection of the upper part (20) and the lower part (22) is provided.

4. The soldering device (10) according to claim 3, wherein the connecting device comprises a bayonet closure and/or a magnet closure.

5. The soldering device (10) according to one of the preceding claims, wherein a heating device (54) designed for heating the solder reservoir (14) is provided and is disposed at least partially in the lower part (22).

6. The soldering device (10) according to one of the preceding claims, wherein a drive device (56) designed for moving the soldering device (10) is provided.

7. The soldering device (10) according to claim 6, wherein the drive device (56) is disposed in the lower part.

8. The soldering device (10) according to claim 6 or 7, wherein the drive device (56) comprises at least one electric motor and at least one drive wheel that is disposed on the lower part (22) and is connected to the electric motor.

9. The soldering device (10) according to one of the preceding claims, wherein an adjusting device (56) designed for relative displacement of the soldering nozzle (16) along a Z axis is provided.

10. The soldering device (10) according to one of the preceding claims, wherein a pressurized storage device (64) designed for storing a compressed gas under an excess pressure is provided in the lower part (22).

11. The soldering device (10) according to claim 10, wherein a first compressed gas line, which can be connected to the pressurized storage device (64), is provided in the lower part (22), and wherein a second compressed gas line, which is disposed in such a way that the second compressed gas line is fluidically connected to the first compressed gas line when the upper part (20) is disposed on the lower part (22) is provided in the upper part (20) .

12. The soldering device (10) according to one of claims 1 to 11, wherein a plurality of permanent magnets (34) is provided, alternately facing the feed channel (12) with a different magnetic pole (36, 38).

## Revendications

1. Dispositif de brasage (10), en particulier creuset de brasage destiné au brasage sélectif à la vague, pourvu d'un réservoir de métal d'apport de brasage (14), qui est configuré pour stocker un métal d'apport de brasage électro-conducteur, en particulier un métal d'apport de brasage liquide, d'une buse de brasage (16) et d'une pompe à métal d'apport de brasage (18), qui est configurée pour refouler le métal d'apport de brasage du réservoir de métal d'apport de brasage (14) en le faisant passer par la buse de brasage (16), dans lequel le dispositif de brasage (10) présente une partie supérieure (20) et une partie inférieure (22), dans lequel la partie supérieure (20) peut être reliée de manière détachable à la partie inférieure (22) et présente le réservoir de métal d'apport de brasage (14) et la buse de brasage (16), dans lequel un canal de refoulement (12) de la pompe à métal d'apport de brasage (18) est agencé dans la partie supérieure (20), et dans lequel un dispositif (32) destiné à produire un champ magnétique mobile de la pompe à métal d'apport de brasage (18) est agencé dans la partie inférieure (22), **caractérisé**
**en ce que** le canal de refoulement (12) s'étend au moins en partie le long d'une trajectoire circulaire (26) s'étendant autour d'un axe de rotation (46), et
**en ce que** le dispositif destiné à produire un champ magnétique mobile comporte au moins un aimant (34) et est configuré de telle manière que l'aimant (34), pendant le fonctionnement, est déplacé autour de l'axe de rotation (46) agencé de manière concentrique par rapport à la trajectoire circulaire (26), le long du canal de refoulement (12), pour produire des courants de Foucault dans le métal d'apport de brasage liquide afin d'accélérer le métal d'apport de brasage liquide dans le canal de refoulement, de sorte que cela permet d'obtenir une action de pompage de la pompe à métal d'apport de brasage (18).

2. Dispositif de brasage (10) selon la revendication 1, dans lequel le canal de refoulement (12) présente une entrée (28) et une sortie (30), dans lequel l'entrée (28) est en liaison fluidique avec le réservoir de métal d'apport de brasage (14) et dans lequel la sortie (30) est en liaison fluidique avec la buse de brasage (16).

3. Dispositif de brasage (10) selon l'une quelconque des revendications précédentes, dans lequel un dispositif de liaison est prévu, qui est configuré pour relier de manière détachable la partie supérieure (20) et la partie inférieure (22).

4. Dispositif de brasage (10) selon la revendication 3, dans lequel le dispositif de liaison comporte une fermeture à baïonnette et/ou une fermeture magnétique.

5. Dispositif de brasage (10) selon l'une quelconque des revendications précédentes, dans lequel un dispositif de chauffage (54) est prévu, qui est agencé au moins en partie dans la partie inférieure (22) et qui est configuré pour chauffer le réservoir de métal d'apport de brasage (14).

6. Dispositif de brasage (10) selon l'une quelconque des revendications précédentes, dans lequel un dispositif d'entraînement (56) est prévu, qui est configuré pour déplacer le dispositif de brasage (10).

7. Dispositif de brasage (10) selon la revendication 6, dans lequel le dispositif d'entraînement (56) est agencé dans la partie inférieure.

8. Dispositif de brasage (10) selon la revendication 6 ou 7, dans lequel le dispositif d'entraînement (56) présente au moins un moteur électrique et au moins une roue motrice qui est agencée sur la partie inférieure (22) et qui est reliée au moteur électrique.

9. Dispositif de brasage (10) selon l'une quelconque des revendications précédentes, dans lequel un dispositif d'avance (56) est prévu, qui est concçu pour déplacer la buse de brasage (16) de manière relative le long d'un axe Z.

10. Dispositif de brasage (10) selon l'une quelconque des revendications précédentes, dans lequel un accumulateur de pression (64), qui est configuré pour accumuler un gaz comprimé sous surpression, est prévu dans la partie inférieure (22).

11. Dispositif de brasage (10) selon la revendication 10, dans lequel une première conduite de gaz comprimé, qui peut être en liaison fluidique avec l'accumulateur de pression (64), est prévue dans la partie inférieure (22), et dans lequel une deuxième conduite de gaz comprimé, qui est agencée de telle sorte que la deuxième conduite de gaz comprimé est en liaison fluidique avec la première conduite de gaz comprimé lorsque la partie supérieure (20) est agencée sur la partie inférieure (22), est prévue dans la partie supérieure (20).

12. Dispositif de brasage (10) selon l'une quelconque des revendications 1 à 11,
dans lequel une pluralité d'aimants permanents (34) sont prévus, qui sont tournés vers le canal de refoulement (12) en alternant un pôle magnétique (36, 38) différent l'un de l'autre.
